Europäisches Patentamt

European Patent Office

Office européen des brevets

(19)

(11) Veröffentlichungsnummer: **0 254 214**
**B1**

(12) # EUROPÄISCHE PATENTSCHRIFT

(45) Veröffentlichungstag der Patentschrift:
26.09.90

(51) Int. Cl.⁵: **H03K 19/094**

(21) Anmeldenummer: 87110300.8

(22) Anmeldetag: 16.07.87

(54) **Integrierbare Schaltung zur Pegelumsetzung.**

(30) Priorität: 21.07.86 DE 3624565

(43) Veröffentlichungstag der Anmeldung:
27.01.88 Patentblatt 88/4

(45) Bekanntmachung des Hinweises auf die Patenterteilung:
26.09.90 Patentblatt 90/39

(84) Benannte Vertragsstaaten:
DE FR GB IT

(56) Entgegenhaltungen:
EP-A- 0 009 083

(73) Patentinhaber: Siemens Aktiengesellschaft,
Wittelsbacherplatz 2, D-8000 München 2(DE)

(72) Erfinder: Einzinger, Josef, Dipl.-Ing., Am Weiher 21,
D-8044 Unterschleissheim(DE)
Erfinder: Fellinger, Christine,
Von-Stauffenbergstrasse 3, D-8025 Unterhaching(DE)
Erfinder: Leipold, Ludwig, Dipl.-Ing., Strassberger
Strasse 125, D-8000 München 40(DE)
Erfinder: Tihanyi, Jenö, Dr., Windeckstrasse 1d,
D-8000 München 70(DE)
Erfinder: Weber, Roland, Dipl.-Ing., Ursulastrasse 5,
D-8000 München 40(DE)

ACTORUM AG

## Beschreibung

Die Erfindung bezieht sich auf eine Schaltungsanordnung zum Umsetzen einer ersten, auf eine Versorgungsspannung bezogenen Signalspannung in eine zweite, auf Massepotential bezogene Signalspannung.

Solche Schaltungsanordnungen werden immer dann benötigt, wenn eine beliebige Spannung, die kleiner ist als die Versorgungsspannung, in eine logikkompatible Spannung umgesetzt werden soll. Da elektronische Logikschaltungen in aller Regel elektrisch an Massepotential liegen, muß die erwähnte erste Signalspannung in eine zweite, auf Massepotential bezogene Signalspannung umgesetzt werden. Diese zweite Signalspannung soll eine zur Verarbeitung in der elektronischen Logikschaltung geeignete Größe haben.

Der Erfindung liegt die Aufgabe zugrunde, eine einfache und integrierbare Schaltungsanordnung anzugeben, die diesen Zweck erfüllt.

Diese Aufgabe wird gelöst durch die Merkmale:

a) zwischen einer ersten und einer zweiten Anschlußklemme liegt eine Reihenschaltung bestehend aus einem MOSFET und mindestens einem Widerstand,

b) der Sourceanschluß des MOSFET ist mit der ersten Klemme verbunden,

c) der Gateanschluß des MOSFET ist mit einer dritten Klemme verbunden,

d) zwischen erster und dritter Klemme ist eine die erste Signalspannung begrenzende erste Zenerdiode angeschlossen,

e) mit demjenigen Anschluß des Widerstandes, der nicht mit der zweiten Klemme verbunden ist, ist eine vierte Klemme verbunden,

f) zwischen der zweiten und vierten Klemme ist eine die zweite Signalspannung begrenzende zweite Zenerdiode angeschlossen.

Weiterbildungen der Erfindung sind Gegenstand der Unteransprüche.

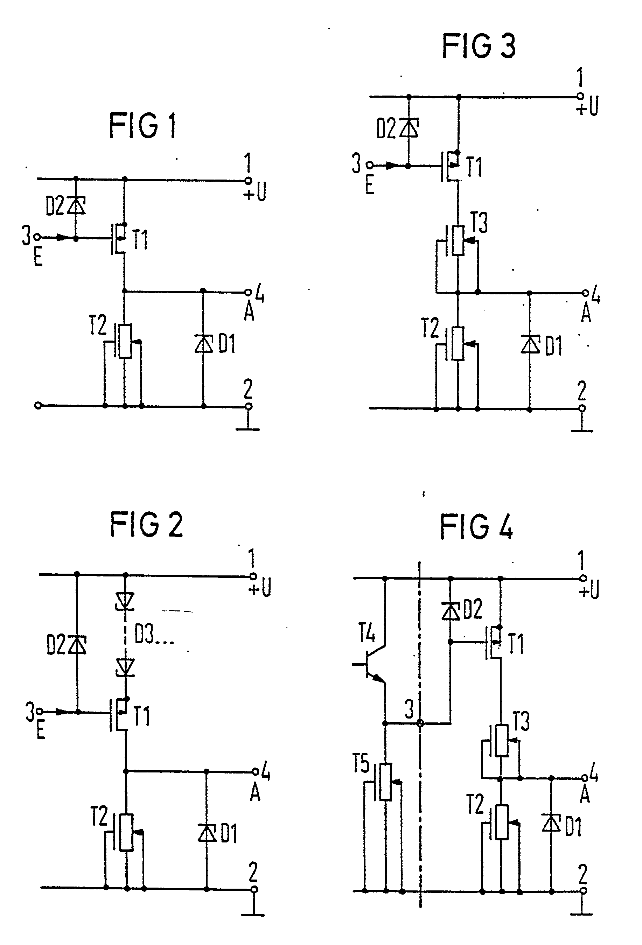

Die Erfindung wird anhand dreier Ausführungsbeispiele in Verbindung mit den Figuren 1 bis 4 näher erläutert. Es zeigen:

Figur 1 bis 3 drei Ausführungsbeispiele der Erfindung und Figur 4 die Anwendung der Schaltung nach Figur 3 zur Temperaturerfassung durch einen Bipolartransistor.

Die Schaltungsanordnung nach Fig. 1 weist eine Reihenschaltung aus einem ersten MOSFET T1 und einem zweiten MOSFET T2 auf. Diese Reihenschaltung liegt über die Klemmen 1 und 2 an einer Versorgungsspannung +U. Die Klemme 2 ist mit Masse verbunden. Der Gateanschluß des MOSFET T1 ist mit einer dritten Klemme 3 verbunden. Der Drainanschluß von T1, der Drainanschluß von T2 bzw. der von der Klemme 2 abgewandte Anschluß von T2 ist mit einer vierten Klemme 4 verbunden. Zwischen der ersten Klemme 1 und der dritten Klemme 3 wird eine erste Signalspannung E angelegt. Zwischen beiden Klemmen liegt eine die erste Signalspannung begrenzende Zenerdiode D2. Zwischen den Klemmen 2 und 4 tritt die zweite Signalspannung A auf. Diese wird durch eine Zenerdiode D1 begrenzt.

Der MOSFET T1 ist ein Enhancement-FET, der bei der eingezeichneten Polarität der Versorgungsspannung vom p-Kanaltyp ist. Der MOSFET T2 ist ein Depletion-FET, in diesem Falle vom n-Kanaltyp. Liegt die Schaltungsanordnung an einer negativen Versorgungsspannung -U, so sind jeweils die komplementären Kanaltypen zu verwenden. Der MOSFET T2 kann auch durch einen ohmschen Widerstand ersetzt werden.

Wird an die Klemmen 1 und 3 die erste Signalspannung angelegt, die kleiner ist als die Einsatzspannung von T1, so bleibt T1 gesperrt. Der Gateanschluß von T2 ist mit seinem Sourceanschluß verbunden. Er wirkt damit als Stromquelle und hat bei gesperrtem Transistor T1 einen sehr geringen Innenwiderstand. An der Klemme 4 liegt daher Massenpotential, das zwischen den Klemmen 4 und 2 anzuschließenden Logikschaltung beispielsweise als Signal L detektiert wird. Wird an die Klemmen 1 und 3 eine die Einsatzspannung von T1 übersteigende Spannung angelegt, so wird T1 eingeschaltet und an der Klemme 4 erscheint ein zwischen dem Potential +U und Massepotential liegendes Potential, dessen Wert durch die Zenerspannung der Zenerdiode D1 festgelegt ist. Dieses Potential liegt, läßt man die Wirkung von D1 unberücksichtigt, umso näher am Potential +U, je größer das Verhältnis der durch T1 und T2 fließenden Ströme ist. Zweckmäßigerweise werden die MOSFET T1 und T2 derart ausgelegt, daß der Stromfluß durch T1 im eingeschalteten Zustand ein Mehrfaches des Stroms durch T2 ist.

Die Schaltungsanordnung nach Fig. 2 unterscheidet sich von der Fig. 1 durch eine oder mehrere Dioden D3, die zwischen den Sourceanschluß von T1 und die erste Klemme 1 eingeschaltet sind. Diese Dioden können beispielsweise Zenerdioden sein. Hierdurch kann die an die Klemmen 1, 3 angelegte erste Signalspannung größer als die Einsatzspannung T1 sein, ohne daß dieser einschaltet. T1 wird erst dann eingeschaltet, wenn die erste Signalspannung die Einsatzspannung zuzüglich der Summe der Schwellspannungen von D3 übersteigt.

In der Schaltungsanordnung nach Fig. 3 ist gegenüber der nach Fig. 1 ein zusätzlicher Depletion-FET T3 vorgesehen, der zwischen dem Drainanschluß von T1 und der Klemme 4 bzw. dem Drainanschluß von T2 bzw. dem von der Klemme 2 abgewandten Seite eines entsprechenden Widerstands angeschlossen ist. T3 begrenzt den Querstrom durch die Schaltung, wenn T1 eingeschaltet ist. Wird hier zwischen den Klemmen 1 und 3 eine erste Signalspannung angelegt, die T1 öffnet, so fließt nun verglichen mit der Schaltungsanordnung nach Fig. 1 ein geringerer Strom durch die Schaltung.

Die erste Signalspannung kann, wie in Fig. 4 dargestellt, durch einen Bipolartransistor T4 erzeugt werden, der in Reihe mit einem weiteren Depletion-MOSFET T5 zwischen den Klemmen 1 und 2 angeschlossen ist. T4 kann beispielsweise in thermischem Kontakt mit einem Leistungshalbleiter-Bauelement, z.B. einem Leistungs-MOSFET, stehen. Erwärmt sich dieses Bauelement, so steigt der Strom durch T4 an. Wird der durch T4 fließende Strom höher als der durch den als Stromquelle geschalteten FET T5, so nimmt der Innenwiderstand von T5 stark zu und die Spannung an der Klemme 3 steigt von Massepotential ausgehend sprungartig an. Wird hierbei die Einsatzspannung von T1 unterschritten, so schaltet dieser aus und das Potential an der Klemme 4 fällt auf Massepotential zurück.

Dieses Potential kann dann wiederum von einer an Klemme 4 angeschlossenen Logik als Signal L detektiert werden und ein Abschalten des Leistungshalbleiter-Bauelementes bewirken.

**Patentansprüche**

1. Schaltungsanordnung zum Umsetzen einer ersten, auf eine Versorgungsspannung bezogenen Signalspannung in eine zweite, auf Massepotential bezogene Signalspannung **gekennzeichnet** durch die Merkmale:
   a) zwischen einer ersten (1) und zweiten Anschlußklemme (2) liegt eine Reihenschaltung bestehend aus einem MOSFET (T1) und mindestens einem Widerstand (T2),
   b) der Sourceanschluß des MOSFET (T1) ist mit der ersten Klemme (1) verbunden,
   c) der Gateanschluß des MOSFET ist mit einer dritten Klemme (3) verbunden,
   d) zwischen erster (1) und dritter Klemme (3) ist eine die erste Signalspannung begrenzende erste Zenerdiode (D2) angeschlossen,
   e) mit demjenigen Anschluß des Widerstandes (T2), der nicht mit der zweiten Klemme verbunden ist, ist eine vierte Klemme (4) verbunden,
   f) zwischen der zweiten (2) und vierten Klemme (4) ist eine die zweite Signalspannung begrenzende zweite Zenerdiode (D1) angeschlossen.

2. Schaltungsanordnung nach Anspruch 1, **dadurch gekennzeichnet,** daß zwischen erster Klemme (1) und Sourceanschluß des MOSFET (T1) mindestens eine Diode (D3) in Stromflußrichtung angeschlossen ist.

3. Schaltungsanordnung nach Anspruch 1 oder 2, **dadurch gekennzeichet,** daß zwischen dem Drainanschluß des MOSFET (T1) und demjenigen Anschluß des Widerstandes (T2), der der zweiten Klemme (2) abgewandt ist, ein weiterer Widerstand (T3) angeschlossen ist.

4. Schaltungsanordnung nach einem der Ansprüche 1 bis 3, **dadurch gekennzeichnet,** daß die Widerstände Depletion-MOSFET sind, bei denen jeweils der Source und der Gateanschluß miteinander verbunden ist.

**Claims**

1. Circuit arrangement for converting a first signal voltage, referenced to a supply voltage, into a second signal voltage, referenced to ground potential, characterized by the following features:
   a) a series circuit comprising a MOSFET (T1) and at least one resistor (T2) is situated between a first (1) and a second connecting terminal (2),
   b) the source connection of the MOSFET (T1) is connected to the first terminal (1),
   c) the gate connection of the MOSFET is connected to a third terminal (3),
   d) a first zener diode (D2) which limits the first signal voltage is connected between first terminal (1) and third terminal (3),
   e) a fourth terminal (4) is connected to that connection of the resistor (T2) which is not connected to the second terminal,
   f) a second zener diode (D1) which limits the second signal voltage is connected between the second terminal (2) and fourth terminal (4).

2. Circuit arrangement according to Claim 1, characterized in that at least one diode (D3) is connected in the direction of current flow between first terminal (1) and source connection of the MOSFET (T1).

3. Circuit arrangement according to Claim 1 or 2, characterized in that a further resistor (T3) is connected between the drain connection of the MOSFET (T1) and that connection of the resistor (T2) which is facing away from the second terminal (2).

4. Circuit arrangement according to one of Claims 1 to 3, characterized in that the resistors are depletion MOSFETs in which the source and gate connection are connected together in each case.

**Revendications**

1. Montage pour convertir une première tension de signal, rapportée à une tension d'alimentation, en une seconde tension de signal rapportée au potentiel de masse, caractérisé par les caractéristiques suivantes:
   a) un circuit série formé d'un transistor MOSFET (T1) et d'au moins une résistance (T2) est disposé entre une première borne de raccordement (1) et une seconde borne de raccordement (2),
   b) la borne de source du transistor MOSFET (T1) est reliée à la première borne (1),
   c) la borne de grille du transistor MOSFET est reliée à une troisième borne (3),
   d) une première diode Zener (D2) limitant la première tension de signal est branchée entre la première borne (1) et la troisième borne (3),
   e) une quatrième borne (4) est reliée à la borne de la résistance (T2), qui n'est pas reliée à la seconde borne,
   f) une seconde diode Zener (D1) limitant la seconde tension de signal est branchée entre la seconde borne (2) et la quatrième borne (4).

2. Montage suivant la revendication 1, caractérisé par le fait qu'au moins une diode (D3) est branchée dans le sens direct entre la première borne (1) et la borne de source du transistor MOSFET (T1).

3. Montage suivant la revendication 1 ou 2, caractérisé par le fait qu'une autre résistance (T3) est branchée entre la borne de drain du transistor MOSFET (T1) et la borne de la résistance (T2), qui est située à l'opposé de la seconde borne (2).

4. Montage suivant l'une des revendications 1 à 3, caractérisé par le fait que les résistances sont des transistors MOSFET à appauvrissement, pour lesquels la source et la borne de grille sont reliées entre elles.

EP 0 254 214 B1

FIG 1

FIG 2

FIG 3

FIG 4